# EUROPÄISCHE PATENTANMELDUNG

(11) **EP 1 791 218 A2**
(43) Veröffentlichungstag der Anmeldung: **30.05.2007**
(21) Anmeldenummer: 06024304.5
(22) Anmeldetag: 23.11.2006
(51) Int. Cl.: H01R 12/22, H01R 12/38

(54) **Elektrischer Verbinder**

(30) Priorität: 23.11.2005 DE 102005056147
(71) Anmelder: Panta GmbH, 01454 Radeberg (DE)
(72) Erfinder: Zeibig, Dietmar, 01454 Radeberg (DE)
(74) Vertreter: Carlsohn, Alexander

(57) **Zusammenfassung**

Die Erfindung betrifft einen Verbinder zum elektrischen Verbinden einer Leiterplatte (7) mit einem weiteren elektrischen Bauteil, wobei das Verbindungselement (1) ein Flachleiterbandkabel (2) mit zumindest einem isolationsfreien Abschnitt (3) umfaßt und der isolationsfreie Abschnitt (3) des Flachleiterbandkabels (2) mit der Leiterplatte (7) in elektrischen Kontakt gebracht werden kann. Dabei ist vorgesehen, daß an einem Segment des Flachleiterbandkabels (1), der an den isolationsfreien Abschnitt (3) des Flachleiterbandkabels (2) angrenzt, ein Fixierungsmittel (10) zur Fixierung des isolationsfreien Abschnittes (3) des Flachleiterbandkabels (2) an der Leiterplatte (7) ausgebildet ist, wobei das Segment des Flachleiterbandkabels (2) in das Fixierungsmittel eingegossen ist.

## Beschreibung

Die Erfindung betrifft einen Verbinder zum elektrischen Verbinden einer Leiterplatte mit einem weiteren elektrischen Bauteil, wobei das Verbindungselement ein Flachleiterbandkabel mit zumindest einem isolationsfreien Ende umfaßt und das isolationsfreie Ende des Flachleiterbandkabels mit der Leiterplatte in elektrischen Kontakt gebracht werden kann.

Flachleiterbandkabel werden vielfach bei der Verkabelung von Maschinen, insbesondere auch von elektrischen Baugruppen in Kraftfahrzeugen verwendet. Zur Herstellung des elektrischen Kontaktes zwischen dem Flachleiterbandkabel und der Leiterplatte der jeweiligen elektrischen Baugruppe wird nach dem Stand der Technik ein Steckverbinder verwendet, der an einem Ende des Flachleiterbandkabels angebracht ist. An der Leiterplatte ist ein Gegenstück zu dem Steckverbinder angebracht, in das der Steckverbinder eingesteckt wird. Auf diese Weise wird der elektrische Kontakt zwischen den Flachleitern des Flachleiterbandkabels und den Leiterbahnen der Leiterplatte sowie die mechanische Verbindung zwischen dem Flachleiterbandkabel und der Leiterplatte hergestellt.

Ein solcher Steckverbinder ist beispielsweise aus DE 200 09 788 bekannt. Der Steckverbinder weist ein Gehäuse auf, das auf der Leiterplatte befestigt werden kann. Im Inneren des Gehäuses ist eine Auflagefläche für die Flachleiterbandkabel vorgesehen, auf der das Kabel mittels eines Klemmelementes fixiert wird. Dabei kontaktieren die isolationsfreien Enden der Leiters des Bandkabels sogenannte Kontaktelemente, die schließlich mit den Leiterbahnen der Leiterplatte elektrisch leitend verbunden sind. Die Befestigung des Gehäuses auf der leiterplatte sorgt für eine wirksame Zugentlastung des Bandkabels nach dessen Verbindung mit der Leiterplatte. Das Gehäuse besteht allerdings aus einer Vielzahl von Einzelteilen, die die Fertigung eines solchen und vergleichbarer Steckverbinder aufwendig machen. Ferner ist eine Anpassung der Fertigung der Steckverbinder an veränderte Bandkabel oder Anschlüsse auf der Leiterplatte nur schwer möglich.

DE 103 21 184 schlägt daher eine Kontaktierungsvorrichtung für flexible Flachleiterbandkabel vor, die an der Oberfläche der Leiterplatte befestigt ist. Die Vorrichtung weist Kontaktelemente auf, die sich in elektrisch leitendem Kontakt mit den Leiterbahnen der Leiterplatte befinden. Ferner ist ein Handhabungselement vorgesehen, das über einer Achse drehbar ist, so daß die Kontaktelemente aus einer Ruhelage in einer Öffnungslage auslenkbar sind. In der Öffnungslage kann das Flachleiterbandkabel in die Kontaktierungsvorrichtung eingeführt werden und wird nach Rückkehr der Kontaktelemente in die Ruhelage auf der Leiterplatte festgeklemmt, wobei die Kontaktelemente in elektrisch leitenden Kontakt mit den isolationsfreien Leiterenden des Flachleiterbandkabels stehen. Die Vorrichtung ermöglicht eine Verbindung des Flachkabels mit der Leiterplatte, ohne daß ein Löt- oder Krimpschritt erforderlich wäre. Dennoch wird ein hinreichender elektrischer Kontakt und eine ausreichende mechanische Festigkeit der Verbindung erreicht.

Nachteil dieser und weiterer bekannter Verbinder zum Verbinden von Flachleiterbandkabeln mit Festplatten ist jedoch die aufwendige Konstruktion der Verbinder sowie der vergleichsweise hohe Aufwand zur deren Fertigung. Ferner ist der Platzbedarf der Verbinder relativ hoch. Überdies ist es bei herkömmlichen Steckverbindern notwendig, zumindest ein Element des Steckverbinders aus der Außenkante der Leiterplatte zu positionieren. Dazu sind jedoch zusätzliche Leiterbahnen erforderlich, die vom Rand der Leiterplatte zu dem Ort auf der Leiterplatte verlaufen, an dem der elektrische Kontakt zwischen den Leitern des Flachleiterbandkabels und der Leiterbahnen ohne dieses Erfordernis hergestellt werden könnte. Ein Anschluß des Flachleiterbandkabels an einem beliebigen Ort auf der Oberfläche der Leiterplatte ist mit derartigen Steckverbindern nicht ohne weiteres möglich.

Aufgabe der Erfindung ist es, die Nachteile nach dem Stand der Technik zu beseitigen. Es soll insbesondere ein Verbinder zum elektrischen Verbinden einer Leiterplatte mit einem weiteren elektrischen Bauteil angegeben werden, daß eine sichere mechanische und elektrische Verbindung an einem frei wählbaren Ort auf der Leiterplatte ermöglicht, wobei der Verbinder möglichst einfach und kostengünstig herstellbar sein soll.

Diese Aufgabe wird durch die Merkmale des Anspruchs 1 gelöst. Zweckmäßige Ausgestaltungen der Erfindungen ergeben sich aus den Merkmalen der Ansprüche 2 bis 18.

Nach Maßgabe der Erfindung ist ein Verbinder zum elektrischen Verbinden einer Leiterplatte mit einem weiteren elektrischen Bauteil vorgesehen, wobei das Verbindungselement ein Flachleiterbandkabel mit zumindest einem isolationsfreien Abschnitt umfaßt und der isolationsfreie Abschnitt des Flachleiterbandkabels mit der Leiterplatte in elektrischen Kontakt gebracht werden kann, wobei an einem Segment des Flachleiterbandkabels, der an den isolationsfreien Abschnitt des Flachleiterbandkabels angrenzt, ein Fixierungsmittel zur Fixierung des isolationsfreien Abschnittes des Flachleiterbandkabels an der Leiterplatte vorgesehen ist und wobei das Segment des Flachleiterbandkabels in das Fixierungsmittel eingegossen ist.

Die Erfindung beruht auf der Erkenntnis, daß es nicht erforderlich ist, ein gesondertes Gehäuse vorzusehen, um ein Flachleiterbandkabel auf der Oberfläche einer Leiterplatte zu befestigen. Statt dessen wird erfindungsgemäß das Fixierungsmittel beispielsweise mittels eines Spritzgießverfahrens ausgebildet, wobei ein Segment des Flachleiterbandkabels in das Fixierungsmittel eingegossen wird. Das Fixierungsmittel ermöglicht dabei einerseits die Fixierung des Endes des Bandkabels auf der Oberfläche der Leiterplatte und sorgt aufgrund seiner Anordnung in unmittelbarer Nachbarschaft zu dem isolationsfreien Ende für dessen Planarität quer zur Längsrichtung des Bandkabels. Die Querplanarität des Bandkabels am isolationsfreien Ende des Bandkabels ist erforderlich, um einen ausreichend sicheren, elektrisch leitenden Kontakt zwischen den Leiterbahnen auf der Leiterplatte und Leitern des Bandkabels an dessen isolationsfreien Ende gewährleisten zu können.

Bei dem weiteren elektrischen Bauteil kann es sich ebenfalls um eine Leiterplatte handeln.

Der Begriff "eingegossen" ist hierbei so zu verstehen, daß das Flachleiterbandkabel an einer Längsseite in das Fixierungsmittel eintritt und dieses an der gegenüberliegenden Seite wieder verläßt. Das Segment des Flachleiterbandkabels, das sich in dem Fixierungsmittel befindet, ist an seiner Oberseite, seiner Unterseite sowie seinen Längsseiten, nicht aber an seinen Querseiten von Material, aus dem das Fixierungsmittel besteht, umschlossen. An die erste Querseite des Segmentes schließt sich das isolationsfreie Ende des Flachleiterbandkabels, an die zweite Querseite des Segmentes der übrige, isolierte Teil des Flachleiterbandkabels an.

Der "isolationsfreie Abschnitt" kann eine isolationsfreies Ende des Flachleiterbandkabels oder eine Abschnitt sein, an den sich in beiden Richtungen längs zur Längsrichtung des Flachleiterbandkabels isolierte Teile des Flachleiterbandkabels anschließen. In beiden Fällen liegen in dem isolationsfreien Abschnitt des Flachleiterbandkabels dessen Flachleiter frei. Die isolationsfreien, d. h. freiliegenden Abschnitte der Flachleiter bilden die Pins, mit denen die Flachleiter elektrisch leitend mit dem elektrischen Bauteil, beispielsweise der Leiterplatte, verbunden werden.

Der Begriff "isolationsfreies Ende des Flachleiterbandkabels" ist somit so zu verstehen, daß an dem Segment des Flachleiterbandkabels, das sich an dessen Ende befindet, die Flachleiter des Flachleiterbandkabels freiliegen. Damit entspricht das isolationsfreie Ende des Flachleiterbandkabels den isolationsfreien Enden der Flachleiter. Die isolationsfreien Enden der Flachleiter bilden die Pins, mit denen die Flachleiter elektrisch leitend mit dem elektrischen Bauteil, beispielsweise der Leiterplatte, verbunden werden.

Zum Verbinden zweier Leiterplatten sind zweckmäßigerweise beide Ende des Flachleiterbandkabels isolationsfreie Enden, wobei an jedem Ende ein Fixierungsmittel vorgesehen ist, wobei in jedes Fixierungsmittel jeweils das Segment des Flachleiterbandkabels eingegossen ist, das an das benachbarte isolationsfreie Ende angrenzt. Der Abstand zwischen den Fixierungsmitteln wird durch die Länge des Flachleiterbandkabels bestimmt und kann daher variieren. Die Erfindung stellt somit einen Verbinder zum Verbinden von elektrischen Bauteilen zur Verfügung, der eine beliebige Länge aufweisen kann.

In einer bevorzugten Ausführungsform weist das isolationsfreie Ende des Flachleiters einen ersten Schenkel auf, der in elektrischem Kontakt mit einer Leiterbahn auf der Oberfläche der Leiterplatte gebracht werden kann, einen zweiten Schenkel, der parallel zu dem ersten Schenkel verläuft und von diesem sowie von der Oberfläche der Leiterplatte in orthogonaler Richtung zur Oberfläche der Leiterplatte beabstandet ist, wenn sich der erste Schenkel in Kontakt mit der Leiterbahn befindet, und ein Verbindungssegment das den ersten Schenkel mit dem zweiten Schenkel verbindet, wobei zwischen dem ersten Schenkel und dem Verbindungssegment ein stumpfer Winkel und zwischen dem Verbindungselement und dem zweiten Schenkel ein stumpfer Winkel ausgebildet ist. Der zweite Schenkel grenzt an den isolierten Teil des Flachleiterbandkabels an. Damit ähneln die isolationsfreien Enden der Leiter des Bandkabels in Seitenansicht der Form eines gestreckten Buchstabens "Z". Die z-förmigen Enden der isolationsfreien Leiter sind Pins zur Verbindung des Bandkabels mit der Leiterplatte.

Die erfindungsgemäßen Verbinder sind oberflächemontierbare Bauelemente (SMD, Surface Mounted Devices), die mittels der SMT-Technologie (Surface Mounted Technology) auf der Leiterplatte appliziert werden können. Ein Verlöten der Leiterbahnen der Leiterplatte mit den isoloationsfreien Leiterenden des Bandkabels ist nicht erforderlich, da aufgrund des Fixierungsmittels die z-förmigen isolationsfreien Enden an die Leiterbahnen der Leiterplatte fest angedrückt werden.

Vorteilhafterweise weist das Fixierungsmittel, in das das Segment des Flachleiterbandkabels eingegossen ist, einen oberen Abschnitt und einen unteren Abschnitt auf, wobei das Segment des Flachleiterbandkabels, parallel zur Oberfläche der Leiterplatte verlaufend, in den oberen Abschnitt des Fixierungsmittel eingegossen ist und wobei der Abstand zwischen dem eingegossenen Segment des Flachleiterbandkabels und der Unterseite des Fixierungsmittel dem Abstand zwischen der Oberfläche der Leiterplatte und dem zweiten Schenkel in orthogonaler Richtung zur Oberfläche der Leiterplatte entspricht, wenn sich die ersten Schenkel in Kontakt mit der Leiterbahn befinden.

Die Begriffe "oberer" und "unterer" Abschnitt beziehen sich auf den Abstand dieser Abschnitte des Fixierungsmittels 10 in orthogonaler Richtung von der Oberfläche der Leiterplatte, auf die das Fixierungsmittel aufgebracht wird.

Im Fall eines isolationsfreie Abschnittes, der nicht an einem Ende des Flachleiterbandkabels ausgebildet ist, ist vorzugsweise u-förmig ausgebildet ist, wobei das u-förmige Profil längs zur Längsrichtung des Flachleiterbandkabels verläuft. Jeweils die Basis des u-förmigen, isolationsfreien Abschnittes eines jeden Flachleiters kann in elektrischen Kontakt mit einer Leiterbahn auf der Oberfläche einer Leiterplatte gebracht werden kann. Die beiden Segmenten des Flachleiterbandkabels, die an den isolationsfreien Abschnitt angrenzen, verlaufen durch ein Fixierungsmittel, das den isolierten Teil des Flachleiterbandkabels von der Leiterplatte beabstandet und den isolationsfreien Abschnitt des Flachleiterbandkabels auf der Oberfläche der Leiterplatte fixiert.

Das Fixierungsmittel umfaßt vorzugsweise
- einen ersten Steg, der quer zur Längsrichtung des Flachleiterbandkabels verläuft, wobei zwischen dem oberen Teil des ersten Steges und dem unteren Teil des ersten Steges eine Öffnung ausgebildet ist, durch die das erste isolierte Segment des Flachleiterbandkabels, das an den isolationsfreien Abschnitt angrenzt, verläuft; und gegebenenfalls
- einen zweiten Steg, der quer zur Längsrichtung des Flachleiterbandkabels verläuft, wobei zwischen dem oberen Teil des zweiten Steges und dem unteren Teil des zweiten Steges eine Öffnung ausgebildet ist, durch die das zweite isolierte Segment des Flachleiterbandkabels, das an den isolationsfreien Abschnitt angrenzt, verläuft.

Vorzugsweise umfaßt das Fixierungsmittel ferner Stifte an der Unterseite des ersten Steges und/oder an der Unterseite des zweiten Steges zur Befestigung des Fixierungsmittels auf der Oberfläche der Leiterplatte.

Es ist besonders bevorzugt, daß der erste Steg und zweite Steg an ihren Enden jeweils mit Querstegen verbunden sind oder, sofern kein zweiter Steg vorgesehen ist, sich von den Enden des ersten Steges Querstege erstrecken.

Das Fixierungsmittel ist vorzugsweise ein massiver Körper aus einem Kunststoff. Es wird vorzugsweise im Spritzgießverfahren hergestellt. Das Fixierungsmittel besteht zweckmäßigerweise aus einem starren Material, um die Querplanarität des angrenzenden isolationsfreien Endes sicherzustellen.

Vorzugsweise liegt die Unterseite des Fixierungsmittels auf der Oberfläche der Leiterplatte auf, wenn sich die ersten Schenkel in Kontakt mit der Leiterbahn befinden. Auf diese Weise wird das Bandkabel mechanisch auf der Leiterplatte fixiert. Das Fixierungsmittel kann auf jede beliebige Weise auf der Oberfläche der Leiterplatte befestigt werden. In einer bevorzugten Ausführungsform sind an der Unterseite des Fixierungsmittels Vorsprünge ausgebildet sind, die in Bohrungen in der Leiterplatte eingepreßt sind, wenn sich die ersten Schenkel in Kontakt mit der Leiterbahn befinden.

Alternativ kann jedoch ein Bügel vorgesehen sein, der an das Fixierungsmittel angegossen oder in dieses eingesteckt ist und aus Metall oder Kunststoff besteht. Der Bügel weist eine ersten Schenkel, einen zweiten Schenkel und ein Verbindungssegment auf, wobei das Verbindungssegment quer zur Längsrichtung des Flachleiterbandkabel an der Oberseite des Fixierungsmittels verläuft. Die beiden Schenkel verlaufen senkrecht zum Verbindungssegment an den Querseiten des Fixierungsmittels. Das freie Ende dieser Schenkel wird in Bohrungen eingepreßt, die an der Oberfläche der Leiterplatte ausgebildet sind.

Anstelle des Bügels können auch Stifte aus Metall oder Kunststoff vorgesehen sein, die an den Querwänden des Fixierungsmittels angegossen oder in diese eingesteckt sind und die senkrecht zu der Oberfläche der Festplatte verlaufen, wobei die unteren freien Enden der Stifte in Bohrungen in der Oberfläche der Leiterplatte eingepreßt werden.

Die Vorsprünge, die an der Unterseite des Fixierungsmittels ausgebildet sind, die unteren freien Enden der Stifte oder die freien Enden der Bügel sind in einer bevorzugten Ausführungsform so ausgebildet, daß sie in die Borungen in der Leiterplatte einschnappen, so daß eine Schnappverbindung zwischen dem Fixierungsmittel und der Leiterplatte entsteht.

Alternativ kann die Unterseite des Fixierungsmittels auf die Leiterplatte aufgeklebt werden.

Bei dem Flachleiterbandkabel handelt es sich vorzugsweise um folienisolierte Flachbandleiter (FIC), bei denen Metallbänder oder -drähte in ein folienartiges Isoliermaterial eingebettet sind. Zur Erhöhung der Flexibilität des Flachleiterbandkabels können in die Isolierung des Flachleiterbandkabels quer zur Längsrichtung des Flachleiterbandkabels verlaufende Einkerbungen eingebracht sein.

Die Erfindung wird nachfolgend unter Bezugnahme auf die Zeichnungen näher beschrieben. Dabei zeigen
- Fig. 1: eine schematische, perspektivische Darstellung einer Ausführungsform eines erfindungsgemäßen Verbinders;
- Fig. 2: eine zweite Ausführungsform des erfindungsgemäßen Verbinders, die ein Fixierungsmittel mit Vorsprüngen an dessen Unterseite aufweist;
- Fig. 3: eine dritte Ausführungsform des erfindungsgemäßen Verbinders, die ein Fixierungsmittel mit Metallstiften aufweist;
- Fig. 4: eine vierte Ausführungsform des erfindungsgemäßen Verbinders, die ein Fixierungsmittel mit einem Bügel aufweist;
- Fig. 5: eine fünfte Ausführungsform des erfindungsgemäßen Verbinders, die ein Fixierungsmittel mit Kunststoffstiften aufweist; und
- Fig. 6: eine sechste Ausführungsform, wobei Fig. 6a einen Schnitt durch das Fixierungsmittel längs zur Längsrichtung des Flachleiterbandkabels und eine vergrößerte Darstellung von Detail A in Fig. 6b ist; Fig. 6b einen weiteren Längsschnitt durch das Fixierungsmittel längs zur Längsrichtung des Flachleiterbandkabels, Fig. 6c eine Draufsicht auf das Flachleiterbandkabel sowie Fig. 6d eine Ansicht quer zur Längsrichtung des Flachleiterbandkabels zeigt.
- Fig. 7: eine siebente Ausführungsform, wobei Fig. 7a einen Schnitt durch das Fixierungsmittel längs zur Längsrichtung des Flachleiterbandkabels und eine vergrößerte Darstellung von Detail A in Fig. 7b ist; Fig. 7b einen weiteren Längsschnitt durch das Fixierungsmittel längs zur Längsrichtung des Flachleiterbandkabels, Fig. 7c eine Draufsicht auf das Flachleiterbandkabel sowie Fig. 7d eine Ansicht quer zur Längsrichtung des Flachleiterbandkabels zeigt.

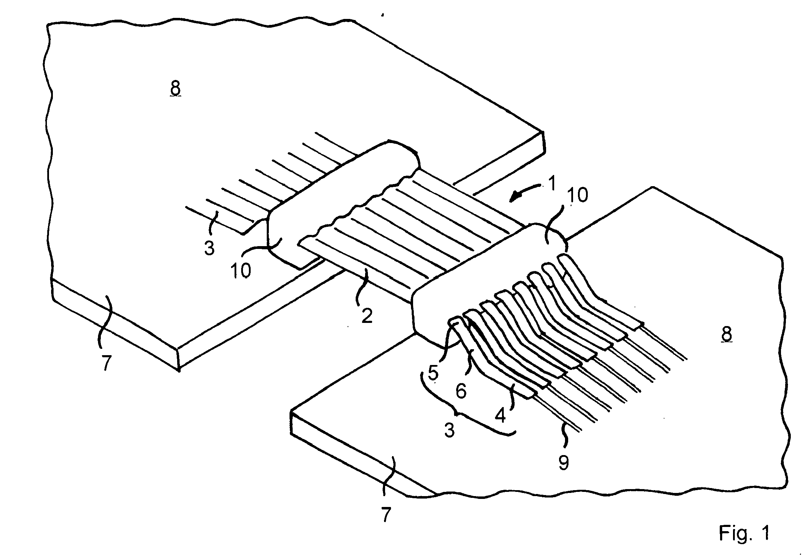

Der in Fig. 1 gezeigte erfindungsgemäße Verbinder 1 besteht aus einem Flachleiterbandkabel 2, an dessen isolationsfreie Enden z-förmige Leiterenden 3 ausgebildet sind. Jedes z-förmige Leiterende weist einen ersten Schenkel 4 auf, der in elektrischem Kontakt mit einer Leiterbahn 9 auf der Oberfläche 8 der Leiterplatten 7 gebracht ist, einen zweiten Schenkel 5, der parallel zu dem ersten Schenkel 4 verläuft und von diesem sowie von der Oberfläche 8 der Leiterplatte 7 orthogonal zur Oberfläche 8 der Leiterplatte 7 beabstandet ist. Der erste Schenkel 4 und der zweite Schenkel 5 sind durch ein Verbindungssegment 6 miteinander verbunden, wobei zwischen dem ersten Schenkel 4 und dem Verbindungssegment 6 ein stumpfer Winkel und zwischen dem Verbindungssegment 6 und dem zweiten Schenkel 5 ein stumpfer Winkel ausgebildet ist. Die isolationsfreien Leiterenden werden im folgenden als Pins bezeichnet.

In die beiden Fixierungsmittel 10 ist jeweils ein Segment des Flachleiterbandkabels eingegossen, das an das benachbarte isolationsfreie Ende 3 angrenzt. Das Segment ist dabei im oberen Abschnitt des Fixierungselementes 10 eingegossen, wobei der Abstand zwischen dem Segment und der Oberfläche 8 der Leiterplatte 7 dem Abstand zwischen den ersten Schenkeln 4 und den zweiten Schenkeln 5 der isolationsfreien Leiter entspricht. Die Fixierungsmittel 10 sind jeweils starre, massive Kunststofformkörper.

Das Flachleiterbandkabel 2 tritt an einer Längsseite 21 in das Fixierungsmittel 10 ein und verläßt dieses an der gegenüberliegenden Längsseite 21 wieder. Das Segment des Flachleiterbandkabels 2, das sich in dem Fixierungsmittel 10 befindet, ist somit an seiner Oberseite, seiner Unterseite sowie seinen Längsseiten, nicht aber an seinen Querseiten von Material, aus dem das Fixierungsmittel besteht umschlossen. An die erste Querseite des Segmentes schließt sich das isolationsfreie Ende 3 des Flachleiterbandkabels 2, an die zweite Querseite des Segmentes der übrige, isolierte Teil des Flachleiterbandkabels 1 an.

Die Unterseite der Fixierungsmittel 10 ist auf den Leiterplatten 7 befestigt.

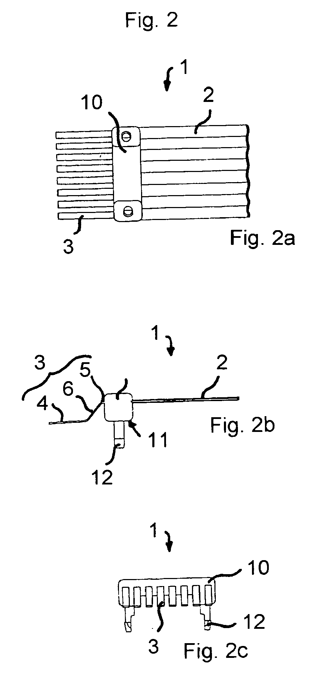

Die Figuren 2 bis 5 zeigen jeweils Ansichten von oben (jeweils Fig. a), von der Seite (jeweils Fig. b) und von vorn (Fig. c, wobei das isolationsfreie Ende, das sich in Kontakt mit der Leiterplatte befindet, vorn dargestellt ist) von Ausführungsformen des erfindungsgemäßen Verbinders 1.

Die in Fig. 2 gezeigte zweite Ausführungsform weist ein Fixierungsmittel auf, an dessen Unterseite 11 Vorsprünge 12 ausgebildet sind, die in Bohrungen, die in der Leiterplatte vorhanden sind, eingepreßt werden können. Die Vorsprünge 12 sind an das Fixierungsmittel 10 angegossen. Sie sind so ausgeformt, daß eine Schnappverbindung zwischen dem Fixierungsmittel 10 und der Leiterplatte 7 geschaffen kann.

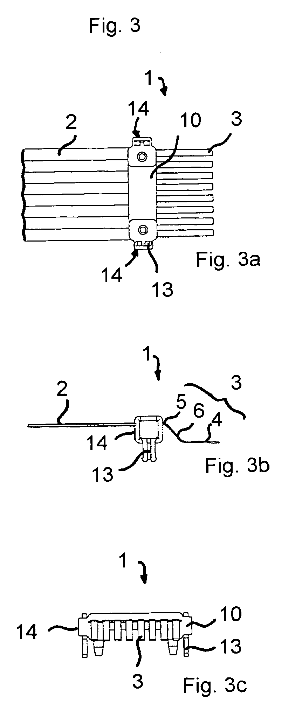

Bei der in Fig. 3 gezeigten dritten Ausführungsform des erfindungsgemäßen Verbinders ist ein Fixierungsmittel vorgesehen, daß Metallstifte 13 aufweist, die an den Querseiten 14 des Fixierungsmittels 10 an dieses angegossen sind. Die Stifte 13 sind so ausgeformt, daß eine Schnappverbindung zwischen dem Fixierungsmittel 10 und der Leiterplatte 7 geschaffen werden kann.

Bei der in Fig. 3 gezeigten dritten Ausführungsform des erfindungsgemäßen Verbinders ist ein Fixierungsmittel 10 vorgesehen, das Metallstifte 13 aufweist, die an den Querseiten 14 des Fixierungsmittels 10 in dort vorgesehene Öffnungen eingesteckt sind. Die Stifte 13 bestehen aus Metall und sind so ausgeformt, daß eine Schnappverbindung zwischen dem Fixierungsmittel 10 und der Leiterplatte 7 geschaffen werden kann.

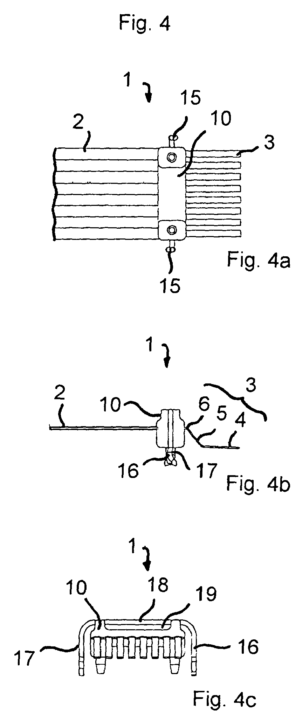

Bei der in Fig. 4 gezeigten vierten Ausführungsform des erfindungsgemäßen Verbinders ist ein Fixierungsmittel 10 vorgesehen, das einen Bügel 15 aus Metall in Form einer Metallspange aufweist. Der Bügel 15 ist an das Fixierungsmittel angegossen und weist einen ersten Schenkel 16, einen zweiten Schenkel 17 und ein Verbindungssegment 18 auf, wobei das Verbindungssegment 18 quer zur Längsrichtung des Flachleiterbandkabels 2 an der Oberseite 19 des Fixierungsmittels 10 verläuft. Die beiden Schenkel 16, 17 verlaufen senkrecht zum Verbindungssegment 18 an den Querseiten des Fixierungsmittels. Das freie Ende dieser Schenkel wird in Bohrungen eingepreßt, die an der Oberfläche 8 der Leiterplatte 7 ausgebildet sind.

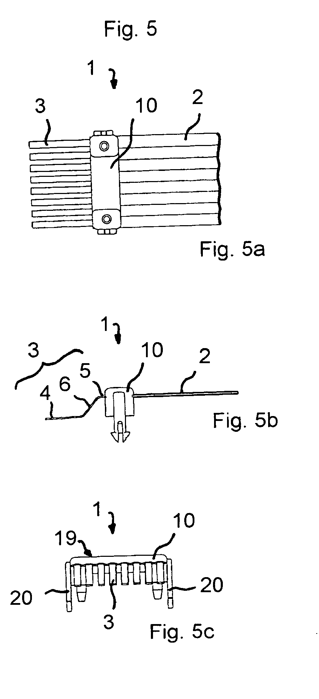

Bei der in Fig. 5 gezeigten fünften Ausführungsform des erfindungsgemäßen Verbinders ist ein Fixierungsmittel 10 vorgesehen, das Kunststoffstifte 20 aufweist, die an den Querseiten 14 des Fixierungsmittels 10 angegossen sind. Die Stifte 20 sind so ausgeformt, daß eine Schnappverbindung zwischen dem Fixierungsmittel 10 und der Leiterplatte 7 geschaffen werden kann.

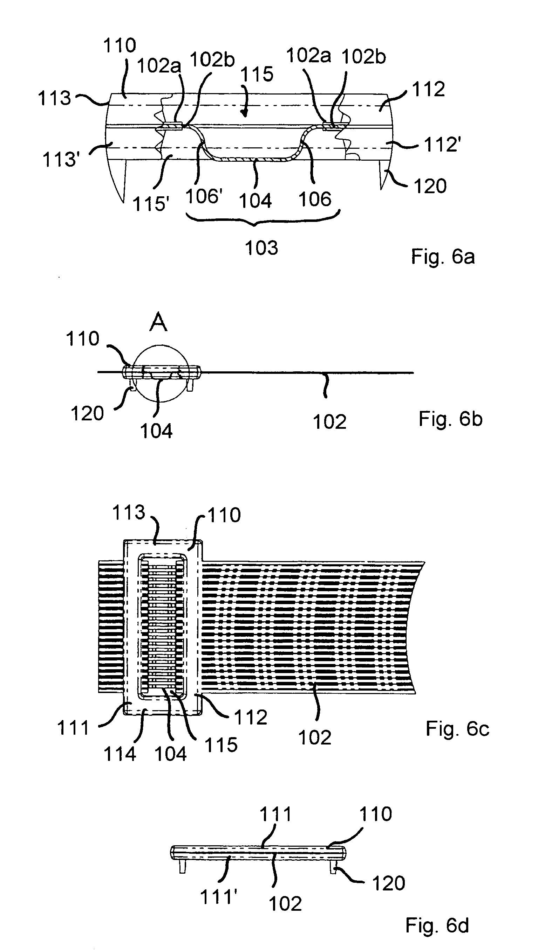

Die in Fig. 6 gezeigte Ausführungsform des erfindungsgemäßen Verbinders 101 weist ein Flachleiterbandkabel 102 mit einem isolationsfreien Abschnitt 103 auf, der die Pins bildet, die auf die Leiterbahn der Leiterplatte 8 aufgebracht werden können. Der isolationsfreie Abschnitt 103 bildet, im Gegensatz zu der ersten bis fünften Ausführungsform, nicht das Ende des Flachleiterbandkabels 102. An jeder der beiden Seiten des isolationsfreien Abschnittes 103 schließt sich somit ein isolierter Abschnitt des Flachleiterbandkabels 102 an. Die Isolierung des Flachleiterbandkabels ist in Fig. 6a mit 102a bezeichnet, während die Flachleiter des Flachleiterbandkabels mit 102b bezeichnet sind.

Die Flachleiter des Flachleiterbandkabels sind im isolationsfreien Abschnitt 103, in bezug auf die Längsrichtung der Leiterbahnen, U-förmig oder annähernd U-förmig ausgebildet. Die Basis 104 des U-förmigen Abschnittes jedes Flachleiters befindet sich in elektrischem Kontakt mit den korrespondierenden Leiterbahnen 9, die auf der Oberfläche einer Leiterplatte 7 ausgebildet sind, wenn der Verbinder 101 auf eine Leiterplatte aufgebracht wird. Die beiden Schenkel 106, 106' des isolationsfreien Abschnittes 103 verbinden dessen Basis 104 mit den an den Abschnitt 103 angrenzenden, von der Oberfläche 8 der Leiterplatte 7 beabstandeten isolierten Abschnitten des Flachleiterbandkabels 102. Der isolationsfreie Abschnitt 103 der Flachleiter umfaßt somit die Basis 104 und die beiden Schenkel 106, 106'.

Das Flachleiterbandkabel 102 ist, abgesehen von der Basis 104 des U-förmigen Abschnittes, von der Oberfläche der Leiterplatte 7 mittels des Fixierungsmittels 110 beabstandet. Das Fixierungsmittel 110 weist an der Unterseite Stifte 120 auf, die in korrespondierende Bohrungen, die in der Leiterplatte ausgebildet sind, eingepreßt werden können. Das Fixierungsmittel sorgt somit für eine dauerhafte Fixierung des Flachleiterbandkabels auf der Oberfläche der Leiterplatte.

Die beiden an den isolationsfreien Abschnitt 103 angrenzenden Segmente des Flachleiterbandkabels 102 sind in das Fixierungsmittel 10 eingegossen, während der isolationsfreie Abschnitt zumindest an seiner Unterseite freiliegt. In Fig. 6c, die eine Draufsicht auf den erfindungsgemäßen Verbinder 101 zeigt, ist zu erkennen, daß auch die Oberseite des isolationsfreien Abschnittes 103 freiliegt, daß heißt, nicht von dem Fixierungsmittel bedeckt ist.

Das in Fig. 6 gezeigte Fixierungsmittel 110 weist einen ersten Steg 111, 111' auf, der quer zur Längsrichtung des Flachleiterbandkabels 102 verläuft. Zwischen dem oberen Teil 111 des ersten Steges und dem unteren Teil 111' des ersten Steges ist eine Öffnung ausgebildet, durch die das isolierte Segment des Flachleiterbandkabels 102, das an den isolationsfreien Abschnitt 103 und dabei den Schenkeln 106 der Flachleiter angrenzt, verläuft. Ebenso verläuft das isolierte zweite Segment des Flachleiterbandkabels 102, das an die Schenkel 106' der Flachleiter angrenzt, durch eine Öffnung zwischen dem oberen Teil 112 und dem unteren Teil 112' eines zweiten Steges. Auch der zweite Steg 112, 112' verläuft quer zur Längsrichtung des Flachleiterbandkabels 102. An der Unterseite des ersten Steges sind zwei Stifte 120 zur Befestigung des Fixierungsmittels auf der Oberfläche der Leiterplatte ausgebildet; ebenso sind an der Unterseite des zweiten Steges zwei weitere Stifte 120 zur Befestigung des Fixierungsmittels auf der Oberfläche der Leiterplatte ausgebildet.

Der erste Steg 111, 111' und zweite Steg 112, 112', die parallel zueinander verlaufen, sind an ihren Enden jeweils mit Querstegen 113, 113' und 114, 114' verbunden. Die Stege umschließen somit den Raum 115, 115', so daß sowohl die Oberseite des isolationsfreien Abschnittes 103 (Teilraum 115) als auch die Unterseite des isolationsfreien Abschnittes 103 (Teilraum 115') freiliegen und nicht bedeckt sind. Es ist jedoch möglich, daß der Teilraum 115 mittels einer Deckplatte abgeschlossen ist. Das Freiliegen des isolationsfreien Abschnittes an dessen Unterseite ermöglicht es, daß die Pins (Basis 104 der isolationsfreien Abschnitte der Flachleiter) auf der Leiterbahn der Leiterplatte elektrisch verbindend aufliegen, wenn das Fixierungsmittel 110 über die Stifte 220 auf der leiterplatte befestigt wird.

Der erste Steg, der zweite Steg, die Stifte 220 sowie Querstege und, falls vorhanden, die Deckplatte sind vorzugsweise einstückig aus einem Kunststoff gegossen, wobei das Flachleiterbandkabel während des Gießens des Fixierungsmittels in dieses eingegossen wird.

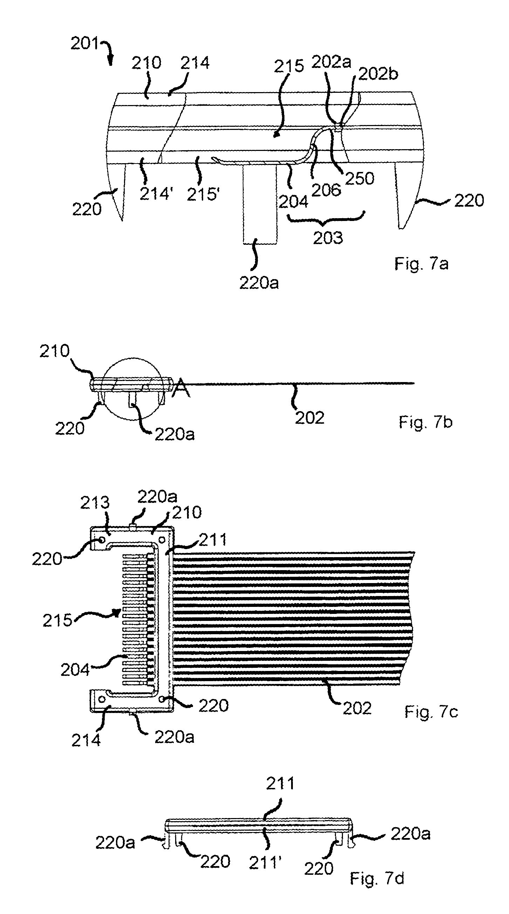

Die in Fig. 7 gezeigte Ausführungsform des erfindungsgemäßen Verbinders 201 weist ein Flachleiterbandkabel 202 mit einem isolationsfreien Abschnitt 203 auf, der die Pins bildet, die auf die Leiterbahn der Leiterplatte 8 aufgebracht werden können. Der isolationsfreie Abschnitt 203 bildet, im Gegensatz zu der sechsten Ausführungsform, das Ende des Flachleiterbandkabels 202. Die Isolierung des Flachleiterbandkabels ist in Fig. 6a mit 202a bezeichnet, während die Flachleiter des Flachleiterbandkabels mit 202b bezeichnet sind.

Die Flachleiter des Flachleiterbandkabels sind im isolationsfreien Abschnitt 203, in bezug auf die Längsrichtung der Leiterbahnen, z-förmig oder annähernd z-förmig ausgebildet. Jedes z-förmige Leiterende weist einen ersten Schenkel 204 auf, der in elektrischem Kontakt mit einer Leiterbahn 9 auf der Oberfläche 8 der Leiterplatten 7 gebracht ist, einen zweiten Schenkel 205, der parallel zu dem ersten Schenkel 204 verläuft und von diesem sowie von der Oberfläche 8 der Leiterplatte 7 orthogonal zur Oberfläche 8 der Leiterplatte 7 beabstandet ist und in dem isolierten Abschnitt 202 endet. Der erste Schenkel 204 und der zweite Schenkel 205 sind durch ein Verbindungssegment 206 miteinander verbunden, wobei zwischen dem ersten Schenkel 204 und dem Verbindungssegment 206 ein stumpfer Winkel und zwischen dem Verbindungssegment 206 und dem zweiten Schenkel 205 ein stumpfer Winkel ausgebildet ist. Der isolationsfreie Abschnitt 203 der Flachleiter umfaßt somit die Schenkel 204, 205 und 206.

Die Flachleiter des Flachleiterbandkabels können jedoch im isolationsfreien Abschnitt 203 ebenso wie in der sechsten Ausführungsform auch u-förmig oder annähernd u-förmig ausgebildet sein.

Das Flachleiterbandkabel 202 ist, abgesehen von dem Schenkel 204 des z-förmigen Abschnittes 203, von der Oberfläche der Leiterplatte 7 mittels des Fixierungsmittels 210 beabstandet. Das Fixierungsmittel 210 weist an der Unterseite Stifte 220 auf, die in korrespondierende Bohrungen, die in der Leiterplatte ausgebildet sind, eingepreßt werden können. Das Fixierungsmittel sorgt somit für eine dauerhafte Fixierung des Flachleiterbandkabels auf der Oberfläche der Leiterplatte.

Das an den isolationsfreien Abschnitt 203 angrenzende Segment des Flachleiterbandkabels 202 ist in das Fixierungsmittel 210 eingegossen, während der isolationsfreie Abschnitt zumindest an seiner Unterseite freiliegt. In Fig. 6c, die eine Draufsicht auf den erfindungsgemäßen Verbinder 201 zeigt, ist zu erkennen, daß auch die Oberseite des isolationsfreien Abschnittes 203 freiliegt, daß heißt, nicht von dem Fixierungsmittel bedeckt ist.

Das in Fig. 6 gezeigte Fixierungsmittel 210 weist einen ersten Steg 211, 211' auf, der quer zur Längsrichtung des Flachleiterbandkabels 202 verläuft. Zwischen dem oberen Teil 111 des ersten Steges und dem unteren Teil 211' des ersten Steges ist eine Öffnung ausgebildet, durch die das isolierte Segment des Flachleiterbandkabels 202, das an den isolationsfreien Abschnitt 103 und dabei den Schenkeln 206 der Flachleiter angrenzt, verläuft. Ein zweiter Quersteg 212 ist im Gegensatz zur sechsten Ausführungsform nicht vorgesehen. An der Unterseite des ersten Steges 211 sind zwei Stifte 220 zur Befestigung des Fixierungsmittels auf der Oberfläche der Leiterplatte ausgebildet.

Von den Enden des ersten Stegs 211, 211' erstrecken sich Querstege 213, 213' und 214, 214' parallel zur Längsrichtung des Flachleiter-Bandkabels in Richtung des isolationsfreien Abschnittes. Die Stege 211, 211', 213, 213' und 214, 214' bilden ein U, das einen Raum 215, 215' umgrenzt, so daß sowohl die Oberseite des isolationsfreien Abschnittes 203 (Teilraum 215) als auch die Unterseite des isolationsfreien Abschnittes 203 (Teilraum 215') freiliegen und nicht bedeckt sind. Im Gegensatz zur sechsten Ausführungsform bildet das Fixierungsmittel 210 keinen geschlossen Rahmen, sondern ist vielmehr zum Ende des Flachleiterbandkabels hin geöffnet. Auf diese Weise können bei einer Erwärmung der Pins 203 und/oder des gesamten Verbinders 201, die mit einer Materialausdehnung verbunden ist, Spannung in dem Fixierungsmittel 210 besser ausgeglichen werden.

Es ist jedoch möglich, daß der Teilraum 215 mittels einer Deckplatte abgeschlossen ist. Das Freiliegen des isolationsfreien Abschnittes an dessen Unterseite ermöglicht es, daß die Pins (Schenkel 204 der isolationsfreien Abschnitte 203 der Flachleiter) auf der Leiterbahn der Leiterplatte elektrisch verbindend aufliegen, wenn das Fixierungsmittel 110 über die Stifte 220 auf der Leiterplatte befestigt wird.

Der erste Steg 211, die Stifte 220, 220a sowie die Querstege 213, 213', 214, 214' und, falls vorhanden, die Deckplatte sind vorzugsweise einstückig aus einem Kunststoff gegossen, wobei das Flachleiterbandkabel während des Gießens des Fixierungsmittels in dieses eingegossen wird.

Vorzugsweise sind an den Außenseiten der Querstege 213, 213', 214, 214' weitere, sich senkrecht in Richtung der Leiterplatte erstreckende Stifte 220a vorgesehen, die in korrespondierende Öffnungen in der Leiterplatte 7 eingreifen können. Die Enden der Stifte 220a, die der Leiterplatte 7 zugewandt sind, weisen hakenförmige Auskragungen auf, die Ausnehmungen in den Öffnungen der Leiterplatte eingreifen können. Mittels dieser Stifte 220a kann ein Ablösen des Verbinders aufgrund von Erwärmung der Pins 204 und/oder des gesamten Verbinders besser verhindert werden. Die Stifte 220a sind vorzugsweise mittig, in bezug auf die Längsachse der Querstege, an den Auskanten der Querstege ausgebildet.

Insgesamt vier Stifte 220 sind vorzugsweise an den Enden der Querstege 213', 214' ausgebildet. Damit sind insgesamt sechs Stifte zur Befestigung des Verbinders 210 an der Leiterplatte vorgesehen.

### Bezugszeichenliste

- 1: Verbinder
- 2: Flachleiterbandkabel
- 3: isolationsfreies Ende (Pins)
- 4: erster Schenkel
- 5: zweiter Schenkel
- 6: Verbindungssegment
- 7: Leiterplatte
- 8: Oberfläche der Leiterplatte 8
- 9: Leiterbahn auf der Leiterplatte 8
- 10: Fixierungsmittel
- 11: Unterseite des Fixierungsmittels 10
- 12: Vorsprünge an der Unterseite 11
- 13: Metallstifte
- 14: Querseite des Fixierungsmittels 10
- 15: Bügel
- 16: erste Schenkel des Bügels 15
- 17: zweiter Schenkel des Bügels 15
- 18: Verbindungssegment des Bügels 15
- 19: Oberseite des Fixierungsmittels 10
- 20: Kunststoffstifte

- 101: Verbinder
- 102: Flachleiterbandkabel
- 103: u-förmiger, isolationsfreier Abschnitt
- 104: Basis des Abschnittes 103
- 106, 106': Schenkel des isolationsfreien Abschnittes
- 110: Fixierungsmittel
- 111: erster Steg des Fixierungsmittels
- 112: zweiter Steg des Fixierungsmittels
- 113, 114: Querstege des Fixierungsmittels
- 115, 115': Raum, der von Stegen 111, 112, 113, 114 umschlossen wird.
- 120: Stifte

- 201: U-förmiger Verbinder
- 202: Flachleiterbandkabel
- 203: z-förmiger, isolationsfreier Abschnitt
- 204: erster Schenkel des Abschnittes 203
- 205: erster Schenkel des Abschnittes 203
- 206: Verbindungssegment des Abschnittes 203
- 210: Fixierungsmittel
- 211: erster Steg des Fixierungsmittels
- 213, 214: Querstege des Fixierungsmittels
- 215, 215': Raum, der von Stegen 111, 113, 114 eingegrenzt wird.
- 220: Stifte
- 220a: hakenartige Stifte

## Patentansprüche

1. Verbinder zum elektrischen Verbinden einer Leiterplatte (7) mit einem weiteren elektrischen Bauteil, wobei das Verbindungselement (1) ein Flachleiterbandkabel (2) mit zumindest einem isolationsfreien Abschnitt(3) umfaßt und der isolationsfreie Abschnitt (3) des Flachleiterbandkabels (2) mit der Leiterplatte (7) in elektrischen Kontakt gebracht werden kann, **dadurch gekennzeichnet, daß** an zumindest einem Segment des Flachleiterbandkabels (2), das an den isolationsfreien Abschnitt (3) des Flachleiterbandkabels (2) angrenzt, ein Fixierungsmittel (10) zur Fixierung des isolationsfreien Abschnittes (3) des Flachleiterbandkabels (2) an der Leiterplatte (7) vorgesehen ist, wobei das Segment des Flachleiterbandkabels (1) in das Fixierungsmittel (10) eingegossen ist.

2. Verbinder nach Anspruch 1, **dadurch gekennzeichnet, daß** der isolationsfreie Abschnitt (3) ein isolationsfreies Ende des Flachleiterbandkabels ist.

3. Verbinder nach Anspruch 2, **dadurch gekennzeichnet, daß** die isolationsfreien Enden (3) der Flachleiter jeweils einen ersten Schenkel (4) aufweisen, der in elektrischen Kontakt mit einer Leiterbahn (9) auf der Oberfläche (8) der Leiterplatte (7) gebracht werden kann; einen zweiten Schenkel (5), der parallel zu dem ersten Schenkel (4) verläuft, an den isolierten Teil des Flachleiterbandkabels (1) angrenzt und von diesem sowie von der Oberfläche (8) der Leiterplatte (7) orthogonal zur Oberfläche (8) der Leiterplatte (7) beabstandet ist, wenn sich der erste Schenkel (4) in Kontakt mit der Leiterbahn (9) befindet; und ein Verbindungssegment (6), das den ersten Schenkel (4) mit dem zweiten Schenkel (5) verbindet; wobei zwischen dem ersten Schenkel (4) und dem Verbindungssegment (6) ein stumpfer Winkel und zwischen dem Verbindungselement (6) und dem zweiten Schenkel (5) ein stumpfer Winkel ausgebildet ist.

4. Verbinder nach Anspruch 3, **dadurch gekennzeichnet, daß** das Fixierungsmittel (10), in das das Segment des Flachleiterbandkabels eingegossen ist, einen oberen Abschnitt und einen unteren Abschnitt aufweist, wobei das Segment des Flachleiterbandkabels (2), parallel zur Oberfläche der Leiterplatte verlaufend, in den oberen Abschnitt des Fixierungsmittel eingegossen ist und wobei der Abstand zwischen dem eingegossenen Segment des Flachleiterbandkabels (1) und der Unterseite (11) des Fixierungsmittels (10) dem Abstand zwischen der Oberfläche (8) der Leiterplatte (7) und dem zweiten Schenkel (5) in orthogonaler Richtung zur Oberfläche (8) der Leiterplatte (7) entspricht, wenn sich die ersten Schenkel (4) in Kontakt mit den Leiterbahnen (9) befinden.

5. Verbinder nach einem Ansprüche 2 bis 4, **dadurch gekennzeichnet, daß** die Unterseite (11) des Fixierungsmittels (10) auf der Oberfläche (8) der Leiterplatte (7) aufliegt, wenn sich die ersten Schenkel (4) in Kontakt mit der Leiterbahn (9) befinden.

6. Verbinder nach einem Ansprüche 2 bis 4, **dadurch gekennzeichnet, daß** an der Unterseite (11) des Fixierungsmittels (10) Vorsprünge (12) ausgebildet sind, die in Bohrungen in der Leiterplatte (7) eingepreßt sind, wenn sich die ersten Schenkel (4) in Kontakt mit den Leiterbahnen (9) befinden.

7. Verbinder nach einem der Ansprüche 2 bis 5, **dadurch gekennzeichnet, daß** die Unterseite (11) des Fixierungsmittels (10) auf die Leiterplatte (7) aufgeklebt ist, wenn sich die ersten Schenkel (4) in Kontakt mit den Leiterbahnen (9) befinden.

8. Verbinder nach einem der Ansprüche 2 bis 7, **dadurch gekennzeichnet, daß** beide Enden des Flachleiterbandkabels 2) isolationsfreie Enden (3) sind, wobei an beiden isolationsfreien Enden (3) des Flachleiterbandkabels (2) jeweils ein Fixierungsmittel (10) vorgesehen ist und wobei in jedes Fixierungsmittel (10) jeweils ein Segment des Flachleiterbandkabels (1) eingegossen ist, das an das benachbarte isolationsfreie Ende (3) angrenzt.

9. Verbinder nach Anspruch 1, **dadurch gekennzeichnet, daß** der isolationsfreie Abschnitt (103) längs zur Längsrichtung des Flachleiterbandkabels (103) u-förmig ausgebildet ist, wobei jeweils die Basis (104) des u-förmigen, isolationsfreien Abschnittes (103) eines jeden Flachleiters in elektrischen Kontakt mit einer Leiterbahn (9) auf der Oberfläche (8) einer Leiterplatte (7) gebracht werden kann und wobei die beiden Segmente des Flachleiterbandkabels, die an den isolationsfreien Abschnitt (103) angrenzen, durch ein Fixierungsmittel (110) verlaufen, das den isolierten Teil des Flachleiterbandkabels (102) von der Leiterplatte beabstandet.

10. Verbinder nach Anspruch 9, **dadurch gekennzeichnet, daß** das Fixierungsmittel
- einen ersten Steg (111, 111'), der quer zur Längsrichtung des Flachleiterbandkabels (102) verläuft, wobei zwischen dem oberen Teil (111) des ersten Steges und dem unteren Teil (111') des ersten Steges eine Öffnung ausgebildet ist, durch die das erste isolierte Segment des Flachleiterbandkabels (102), das an den isolationsfreien Abschnitt (103) angrenzt, verläuft; und
- einen zweiten Steg (112, 112'), der quer zur Längsrichtung des Flachleiterbandkabels (102) verläuft, wobei zwischen dem oberen Teil (112) des zweiten Steges und dem unteren Teil (112') des zweiten Steges eine Öffnung ausgebildet ist, durch die das zweite isolierte Segment des Flachleiterbandkabels (102), das an den isolationsfreien Abschnitt (103) angrenzt, verläuft, umfaßt.

11. Verbinder nach Anspruch 10, **dadurch gekennzeichnet, daß** das Fixierungsmittel ferner Stifte (120) an der Unterseite des ersten Steges und/oder an der Unterseite des zweiten Steges zur Befestigung des Fixierungsmittels (110) auf der Oberfläche der Leiterplatte umfaßt.

12. Verbinder nach Anspruch 9 oder Anspruch 10, **dadurch gekennzeichnet, daß** der erste Steg (111, 111') und der zweite Steg (112, 112') an ihren Enden jeweils mit Querstegen 113, 113' und 114, 114' verbunden sind.

13. Verbinder nach Anspruch 1, **dadurch gekennzeichnet, daß** der isolationsfreie Abschnitt (203) längs zur Längsrichtung des Flachleiterbandkabels (203) z-förmig ausgebildet ist, wobei
- jeweils ein erster Schenkel (204) des z-förmigen, isolationsfreien Abschnittes (203) eines jeden Flachleiters in elektrischen Kontakt mit einer Leiterbahn (9) auf der Oberfläche (8) einer Leiterplatte (7) gebracht werden kann;
- das Segment des Flachleiterbandkabels, das an den isolationsfreien Abschnitt (203) angrenzt, durch ein Fixierungsmittel (210) verläuft, das den isolierten Teil des Flachleiterbandkabels (202) von der Leiterplatte beabstandet; und
wobei das Fixierungsmittel (210)
- einen ersten Steg (211, 211'), der quer zur Längsrichtung des Flachleiterbandkabels (202) verläuft, wobei zwischen dem oberen Teil (211) des ersten Steges und dem unteren Teil (211') des ersten Steges eine Öffnung ausgebildet ist, durch die das isolierte Segment des Flachleiterbandkabels (202), das an den isolationsfreien Abschnitt (203) angrenzt, verläuft; und
- zwei Querstege (213, 113' sowie 214, 214'), die sich von den Enden des ersten Steges (211, 211') parallel zu der Längsachse des Flachleiterbandkabels zum Ende des isolationsfreien Abschnittes (203) erstrecken, wobei der erste Steg und die beiden Querstege ein U bilden;
umfaßt.

14. Verbinder nach Anspruch 13, **dadurch gekennzeichnet, daß** das Fixierungsmittel ferner Stifte (220) an der Unterseite des ersten Steges (211, 211') und/oder an der Unterseite der Querstege (213, 113' sowie 214, 214') zur Befestigung des Fixierungsmittels (210) auf der Oberfläche der Leiterplatte umfaßt.

15. Verbinder nach Anspruch 13 oder Anspruch 14, **dadurch gekennzeichnet, daß** mittig an den Außenseiten der Querstege (213, 113' sowie 214, 214') weitere Stifte (220a) vorgesehen sind, an deren Enden hakenartige Auskragungen vorgesehen sind, die in korrespondierende Ausnehmungen in der Leiterplatte eingreifen können.

16. Verbinder nach einem der vorstehenden Ansprüche, **dadurch gekennzeichnet, daß** das Fixierungsmittel (10, 110) ein massives Formteil ist.

17. Verbinder nach einem der vorstehenden Ansprüche, **dadurch gekennzeichnet, daß** das Fixierungsmittel (10, 110) ein Kunststofformteil ist.

18. Verbinder nach einem der vorstehenden Ansprüche, **dadurch gekennzeichnet, daß** in die Isolierung des Flachleiterbandkabels quer zur Längsrichtung des Flachleiterbandkabels verlaufende Einkerbungen eingebracht sind.
